# EUROPEAN PATENT APPLICATION

(11) **EP 3 054 442 A1**
(43) Date of publication of application: **10.08.2016**
(21) Application number: 16154284.0
(22) Date of filing: 04.02.2016
(51) Int. Cl.: G09G 3/20, G02F 1/1345, H05K 1/18, G09G 3/32

(54) **DISPLAY DEVICE**

(30) Priority: 05.02.2015 KR 20150017741
(71) Applicant: Samsung Display Co., Ltd., Gyeonggi-do 17113 (KR)
(72) Inventor: SEO, Hae Kwan, Gyeonggi-Do (KR)
(74) Representative: Taor, Simon Edward William

(57) **Abstract**

Exemplary embodiments disclose a display device, including: a display panel including: pixels configured to display an image; driving integrated circuits (ICs) configured to generate and apply a pixel driving signal for driving the pixels; and at least one signal transmission unit configured to electrically connect the driving ICs to one another, and the signal transmission unit are disposed on a surface of the display panel, spaced apart from the surface of the display panel by a first distance; and a printed circuit board (PCB) including a controller configured to receive an image signal from an external source, generate a driving control signal, and apply the driving control signal to the driving ICs.

## Description

Exemplary embodiments relate to a display device, and more particularly, to a display device including a plurality of driving integrated circuits (ICs).

As the "Information Society" continues to develop, the demand for thin, lightweight flat panel display (FPD) devices has steadily grown. Examples of FPD devices include a liquid crystal display (LCD) device, an electrophoretic display (EPD) device, an organic light-emitting display device, an inorganic electro-luminescent (EL) display device, a field emission display (FED) device, a surface-conduction electron-emitter display (SED) device, a plasma display panel (PDP) device, and a cathode ray tube (CRT) display device.

An FPD device includes a display area including a plurality of pixels arranged to display an image and a non-display area including a plurality of driving integrated circuits (ICs) disposed for driving the plurality of pixels.

The driving ICs disposed in the non-display area may be implemented as chips mounted on a display panel in a chip-on-glass (COG) manner or in a tape carrier package (TCP) manner using tape automated bonding (TAB).

The driving ICs mounted in the non-display area of the display panel are electrically connected to a controller on a printed circuit board (PCB) using a multi-drop method or a point-to-point method.

The point-to-point method, rather than a relatively low-speed multi-drop method, may have a relatively high speed for high-resolution and high-operating speed display devices.

The point-to-point method, however, connects the controller on the PCB one-on-one to the driving IC, and thus requires a relatively high number of wires to provide a high-speed interface.

In the point-to-point method, a high-speed interface is established using line-on-glass (LOG)-type transmission lines installed on a substrate. However, it is not easy to electrically connect the driving ICs, which are mounted in a COG manner and arranged along a horizontal direction, to the controller by using the LOG-type transmission lines, which are arranged along a vertical direction. Also, it is difficult to provide a high-speed interface due to the relatively high number of transmission lines required.

The above information disclosed in this Background section is only for enhancement of understanding of the background of the inventive concept, and, therefore, it may contain information that does not form the prior art that is already known in this country to a person of ordinary skill in the art.

Exemplary embodiments provide a display device including a high-speed interface by improving data transmission between a controller and a plurality of driving integrated circuits (ICs) provided in a non-display area, and thus may transmit data at high speed and provide a high-resolution image.

Exemplary embodiments may also provide a display device having a printed circuit board (PCB) with a reduced size such that the display panel may have a curvature or be formed of a flexible material.

Additional aspects will be set forth in the detailed description which follows, and, in part, will be apparent from the disclosure, or may be learned by practice of the inventive concept.

Exemplary embodiments disclose a display device, including: a display panel including: with pixels configured to display an image; driving integrated circuits (ICs) configured to generate and apply a pixel driving signal for driving the pixels; and at least one signal transmission unit configured to electrically connect the driving ICs to one another. The signal transmission unit is disposed on a surface of the display panel, spaced apart from the surface of the display panel by a first distance. The display device also includes a printed circuit board (PCB) including a controller configured to receive an image signal from an external source, generate a driving control signal, and apply the driving control signal to the driving ICs.

Exemplary embodiments also disclose a display device with a display area including pixels, the display being configured to display an image. A non-display area of the display device includes a first driving IC configured to apply a pixel driving signal to the pixels; and a second driving IC disposed adjacent to the first driving IC; and a controller electrically connected to the first driving IC, the controller configured to receive an image signal from an external source and configured to apply a driving control signal to the first driving IC. Each of the first driving IC and the second driving IC may include first pads disposed on first surfaces of the first driving IC and the second driving IC contacting the non-display area; and second pads disposed on second surfaces of the first driving IC and the second driving IC, the second surfaces being opposite to first surfaces.

Exemplary embodiments also disclose a display device, comprising: a display panel comprising: a plurality of pixels configured to display an image; a first driving integrated circuit IC and a second driving integrated circuit IC configured to generate and apply a pixel driving signal for driving the pixels; and a signal transmission unit configured to electrically connect the first driving IC to the second driving IC, the signal transmission unit being disposed over a surface of the display panel and being spaced apart from the surface of the display panel by a first distance; and a PCB comprising a controller configured to receive an image signal from an external source, generate a driving control signal, and apply the driving control signal to the first and second driving ICs. Such embodiments may include a number of driving ICs, with adjacent driving ICs being connected by a signal transmission unit.

According to an aspect of the invention, there is provided a display device as set out in claim 1. Preferred features are set out in claims 2 to 7.

According to an aspect of the invention, there is provided a display device as set out in claim 8. Preferred features are set out in claims 9 to 15.

The foregoing general description and the following detailed description are exemplary and explanatory and are intended to provide further explanation of the claimed subject matter.

The accompanying drawings, which are included to provide a further understanding of the inventive concept, and are incorporated in and constitute a part of this specification, illustrate exemplary embodiments of the inventive concept, and, together with the description, serve to explain principles of the inventive concept.
FIG. 1 is a schematic plan view of a display device according to one or more exemplary embodiments.
FIG. 2 is a schematic cross-sectional view illustrating exemplary connections between a plurality of driving ICs and a plurality of signal transmission units of the display device according to an exemplary embodiment.
FIGS. 3, 4, and 5 are schematic top plan views illustrating exemplary arrangements of the driving ICs and the signal transmission units illustrated in FIG. 2.
FIG. 6 is a schematic cross-sectional view illustrating exemplary connections between the driving ICs and the signal transmission units of the display device according to an exemplary embodiment.
FIG. 7 is a schematic top plan view illustrating the driving ICs and the signal transmission units of FIG. 6.
FIG. 8 is a schematic bottom plan view illustrating the driving ICs and the signal transmission units of FIG. 6.
FIG. 9 is a schematic cross-sectional view illustrating exemplary connections between the driving ICs and the signal transmission units of the display device according to an exemplary embodiment.
FIG. 10 is a schematic top plan view illustrating the driving ICs and the signal transmission units of FIG. 9.
FIG. 11 is a schematic cross-sectional view of an example of a driving IC of the display device according to an exemplary embodiment, taken along a sectional line I-I' of FIG. 3.
FIG. 12 is aa schematic cross-sectional view of an example of a driving IC of the display device according to an exemplary embodiment, taken along the sectional line I-I' of FIG. 3.
FIG. 13 is a block diagram illustrating exemplary transmissions of signals in the display device according to an exemplary embodiment.
FIGS. 14, 5, and 16 are schematic plan views of first, second, and third driving ICs, respectively, illustrated in FIG. 13.
FIG. 17 is a block diagram illustrating an exemplary transmission of signals in the display device according to an exemplary embodiment.
FIGS. 18, 9, and 20 are schematic plan views of first, second, and third driving ICs, respectively, illustrated in FIG. 17.
FIG. 21 is a schematic block diagram illustrating exemplary transmissions of signals in the display device according to an exemplary embodiment.
FIG. 22 is a perspective view of a curved display device including a signal transmission substrate and a control substrate of the display device, according to an exemplary embodiment.
FIG. 23 is a schematic plan view of a display device according to an exemplary embodiment.
FIG. 24 is a schematic plan view of a display device according to an exemplary embodiment.

In the following description, for purposes of explanation, numerous specific details are set forth in order to provide a thorough understanding of various exemplary embodiments. It is apparent, however, that various exemplary embodiments may be practiced without these specific details or with one or more equivalent arrangements. In other instances, well-known structures and devices are shown in block diagram form in order to avoid unnecessarily obscuring various exemplary embodiments.

In the accompanying figures, the size and relative sizes of layers, films, panels, regions, etc., may be exaggerated for clarity and descriptive purposes. Also, like reference numerals denote like elements.

When an element or layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. Like numbers refer to like elements throughout. As used herein, the term "and/or" includes any and all combinations of one or more of the associated listed items.

Although the terms first, second, etc. may be used herein to describe various elements, components, regions, layers, and/or sections, these elements, components, regions, layers, and/or sections should not be limited by these terms. These terms are used to distinguish one element, component, region, layer, and/or section from another element, component, region, layer, and/or section. Thus, a first element, component, region, layer, and/or section discussed below could be termed a second element, component, region, layer, and/or section without departing from the teachings of the present disclosure.

Spatially relative terms, such as "beneath," "below," "lower," "above," "upper," and the like, may be used herein for descriptive purposes, and, thereby, to describe one element or feature's relationship to another element(s) or feature(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof.

Various exemplary embodiments are described herein with reference to sectional illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not be construed as limited to the particular illustrated shapes of regions, but are to include deviations in shapes that result from, for instance, manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and will not be interpreted in an idealized or overly formal sense, unless expressly so defined herein.

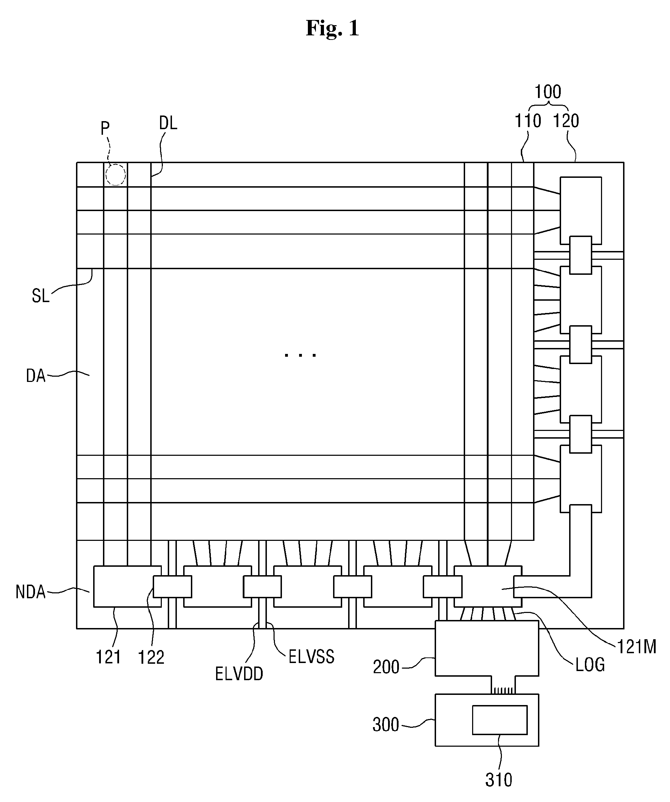

FIG. 1 is a schematic plan view of a display device according to an exemplary embodiment.

Referring to FIG. 1, the display device according to an exemplary embodiment may include a panel substrate 100, a signal transmission substrate 200 and a control substrate 300.

The panel substrate 100 may include a first substrate 110 and a second substrate 120. The first substrate 110 and the second substrate 120 may be formed of at least one of a glass material, an insulating material, and a flexible material. A plurality of light-emitting elements may be disposed between the first substrate 110 and the second substrate 120 to display an image, and an area where the light-emitting elements are disposed may be referred to as a display area DA. A non-display area NDA may refer to area where image is not displayed, and may be provided on the second substrate 120.

In the display area DA, a plurality of scan lines SL, a plurality of data lines DL, and a plurality of pixels P may be disposed. Each of the pixels P may include at least one switching element, for example, thin-film transistors (TFTs), which may be turned on or off according to a control signal applied thereto from the control substrate 300, and a light-emitting element that may emit light under the control of the switching elements.

The non-display area NDA may include a plurality of driving integrated circuits (ICs) 121 connected to the scan lines SL and the data lines DL in the display area DA and configured to apply driving control signals to drive the pixels P disposed in the display area DA, a plurality of signal transmission units 122 configured to electrically connect the driving ICs 121 and transmitting signals between the driving ICs 121, power lines ELVDD and ELVSS configured to apply power to the display area DA, and line-on-glass (LOG)-type transmission lines LOG configured to transmit signals between the driving ICs 121 and the signal transmission substrate 200. The driving ICs 121 may be mounted on the second substrate 120 in a chip-on-glass (COG) manner. Referring to FIG. 1, the power lines ELVDD and ELVSS are disposed in the non-display area NDA, but the exemplary embodiments are not limited thereto. The power lines ELVDD and ELVSS are not disposed on the signal transmission substrate 200 in this embodiment. The driving ICs 121 may include at least one main driving ICs 121M. The main driving ICs 121M may be connected to the signal transmission substrate 200 and/or the control substrate 300.

The driving ICs 121 may include one or more main driving ICs 121M, and therefore, some of the driving ICs 121 may be main driving ICs 121M, and a display device according to an exemplary embodiment may include at least one main driving ICs 121M. Accordingly, some of the driving ICs 121, i.e., the main driving ICs 121M, may be connected to the signal transmission substrate 200 and/or the control substrate 300, and as a result, the size of the signal transmission substrate 200 and/or the control substrate 300 may be reduced. Each of the driving ICs 121 may include at least one pad on at least one of the top surface, bottom surface, and side surfaces thereof, and the signal transmission units 122 may be electrically connected to the pads of the driving ICs 121. The connections between the driving ICs 121 and the signal transmission units 122 will be described later in detail.

The signal transmission substrate 200 may be disposed between the panel substrate 100 and the control substrate 300 and may electrically connect the panel substrate 100 and the control substrate 300. The signal transmission substrate 200 may transmit data and control signals received from the control substrate 300 to the panel substrate 100. The signal transmission substrate 200 may be a printed circuit board (PCB) formed of a flexible material, i.e., a flexible PCB (FPCB).

The control substrate 300 may include a controller 310, which is electrically connected to the panel substrate 100 via the signal transmission substrate 200 and controls the operation of the driving ICs 121.

The controller 310 may be electrically connected via the signal transmission substrate 200 to some of the driving ICs 121, and particularly, the main driving ICs 121M, of the panel substrate 100. The controller 310 may generate a data signal based on source data input thereto from an external source (not illustrated), may generate a control signal for controlling the driving timing of the driving ICs 121, and may transmit the data signal and the control signal to the main driving ICs 121M.

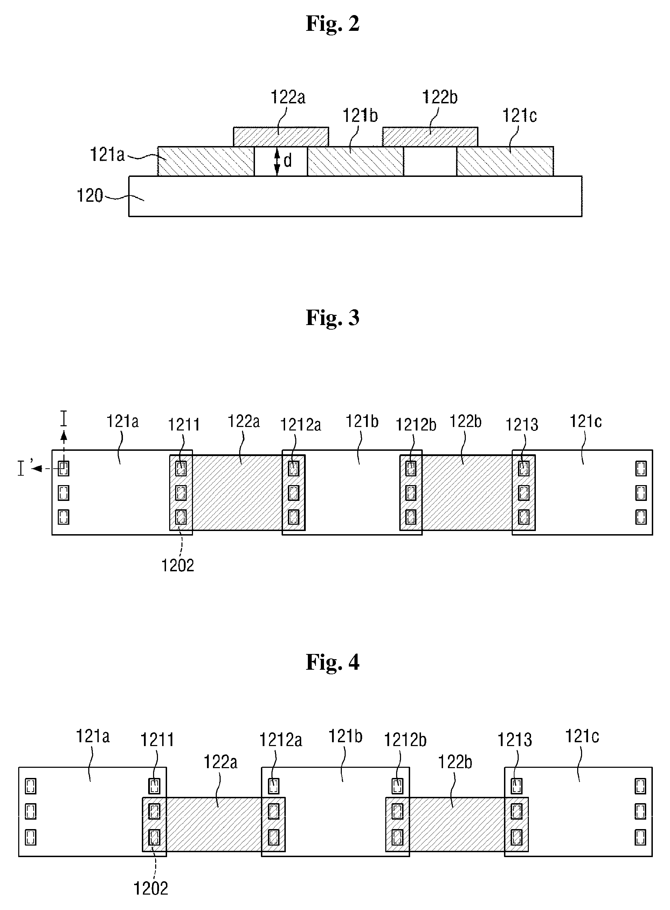

FIG. 2 is a schematic cross-sectional view illustrating exemplary connections between the driving ICs 121 and the signal transmission units 122, and FIGS. 3, 4, and 5 are schematic top plan views illustrating exemplary arrangements of the driving ICs 121 and the signal transmission units 122, according to an exemplary embodiment.

For convenience, the driving ICs 121 and the signal transmission units 122 will hereinafter be described, with reference to first, second, and third driving ICs 121a, 121b, and 121c and first and second signal transmission units 122a and 122b.

Referring to FIG. 2, the display device according to an exemplary embodiment may include the first, second, and third driving ICs 121a, 121b, and 121c, which are mounted on the second substrate 120. The first, second, and third driving ICs 121a, 121b, and 121c may be electrically connected to one another by the first and second signal transmission units 122a and 122b, which connect a plurality of pads 1211, 1212a, 1212b, or 1213 that are arranged on a first and/or second side of the top surface, the side surface and/or the bottom surface of the first, second, and third driving IC 121a, 121b, and 121c. The first and second signal transmission units 122a and 122b may be metal plates (for example, metal foils) and/or FPCBs. The first and second signal transmission units 122a and 122b may be disposed spaced apart from the second substrate 120 by a first distance d, which may be substantially the thickness of the driving ICs. An insulating material may be disposed in the gaps between the second substrate 120 and the first and second signal transmission units 122a and 122b to reduce or prevent signal interference between the power lines ELVDD and ELVSS or the LOG-type transmission lines LOG, which are disposed on the second substrate 120. At least one of the first, second, and third driving ICs 121a, 121b, and 121c may be main driving ICs 121M, which receive the data signal and the control signal from the control substrate 300. Since the first, second, and third driving ICs 121a, 121b, and 121c transmit signals to one another via the first and second signal transmission units 122a and 122b, an interface for high-speed data transmission may be provided.

Referring to FIGS. 3, 4, and 5, the first, second or third driving IC 121a, 121b, and 121c may include plurality of through silicon vias (TSVs) 1202, and a plurality of pads may be disposed on the bottom surfaces of each of the first, second, and third driving ICs 121a, 121b, and 121c that contacts the second substrate 120, and on the top surfaces of each of the first, second, and third driving ICs 121a, 121b, and 121c.

The first and second driving ICs 121a and 121b may be electrically connected by the first signal transmission unit 122a, which connects a plurality of first pads 1211 that are disposed on a second side of the top surface of the first driving IC 121a and a plurality of 2a pads 1212a that are formed on a first side of the top surface of the second driving IC 121b. Hence, a first end portion of the signal transmission unit 122a contacts the top surface of the first driving IC 121a, and a second side portion of the signal transmission unit 122a contacts the top surface of the second driving IC 121b. When the first driving IC 121a is the main driving IC 121M configured to receive data and the control signal from the control substrate 300, the first pads 1211 on the first side of the top surface of the first driving IC 121a may be signal transmitting pads Tx, which transmit the control signal generated by the first driving IC 121a based on the received data and control signal to the second driving IC 121b, and the 2a pads 1212a disposed on the first side of the top surface of the second driving IC 121b may be signal receiving pads Rx, which receive the control signal generated by the first driving IC 121a. The transmission of signals between the first and second driving ICs 121a and 121b will be described later in detail.

The second and third driving ICs 121b and 121c may be electrically connected by the second signal transmission unit 122b, which connects a plurality of 2b pads 1212b disposed on a second side of the top surface of the second driving IC 121b and a plurality of third pads 1213 disposed on a first side of the top surface of the third driving IC 121c.

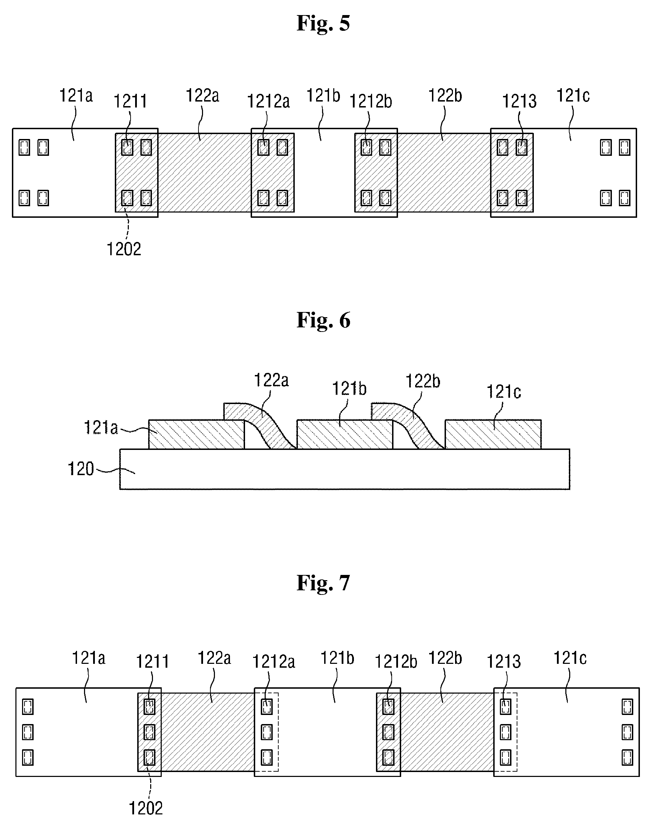

The first pads 1211, the 2a and 2b pads 1212a and 1212b, and the third pads 1213, which are disposed on the top surfaces of the first, second, and third driving ICs 121a, 121b, and 121c, respectively, may be arranged in a vertical direction in a single column on one side of the top surfaces of the first, second, and third driving ICs 121a, 121b, and 121c, respectively, as illustrated in FIGS. 3 and 4, or may be arranged in the vertical direction in two or more columns on one side of the top surfaces of the first, second, and third driving ICs 121a, 121b, and 121c, respectively, as illustrated in FIG. 5.

The first signal transmission unit 122a may be disposed over all of the first pads 1211 disposed on a second side of the first driving IC 121a and all of the 2a pads 1212a disposed on the first side of the second driving IC 121b, and the second signal transmission unit 122b may be disposed over all of the 2b pads 1212b disposed on the second side of the second driving IC 121b and all of the third pads 1213 disposed on the first side of the third driving IC 121c, as illustrated in FIGS. 3 and 5. The first signal transmission unit 122a may be disposed over some of the first pads 1211 and some of the 2a pads 1212a, and the second signal transmission unit 122b may be disposed over some of the 2b pads 1212b and some of the third pads 1213, as illustrated in FIG. 4.

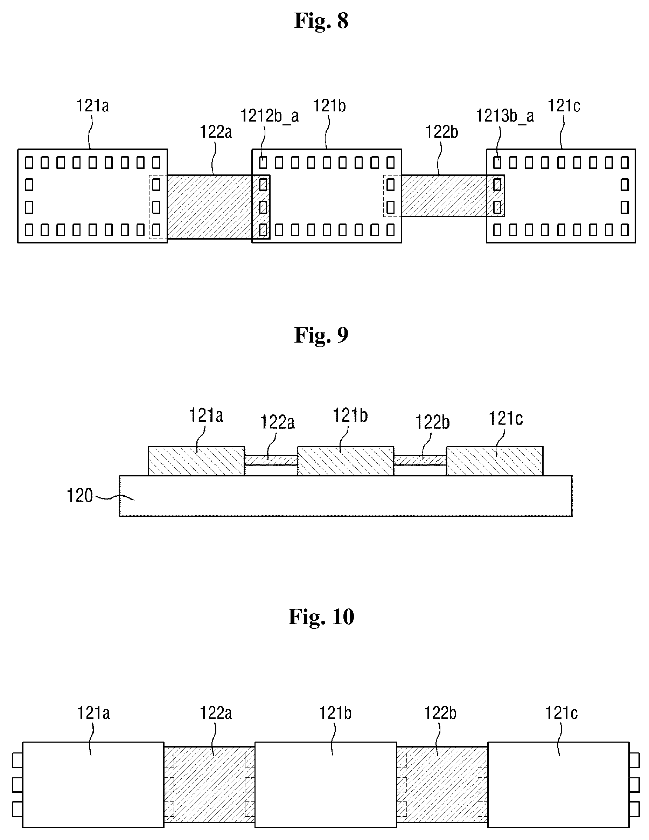

FIG. 6 is a schematic cross-sectional view illustrating exemplary connections between the driving ICs 121 and the signal transmission units 122 of the display device according to an exemplary embodiment, FIG. 7 is a schematic top plan view illustrating the driving ICs 121 and the signal transmission units 122 of FIG. 6, and FIG. 8 is a schematic bottom plan view illustrating the driving ICs 121 and the signal transmission units 122 of FIG. 6.

Referring to FIGS. 6, 7, and 8, the first signal transmission unit 122a does not electrically connect pads disposed on the top surfaces of the first driving IC 121a and the second driving IC 121b, and the second signal transmission unit 122b does not electrically connect pads disposed on the top surface of the second driving IC 121b and the third driving IC 121c. Instead, the first signal transmission unit 122a may be connected to the pads disposed on the top surface of the first driving IC 121a on second side thereof and pads disposed on the bottom surface of the second driving ICs 121b on the first side thereof. The pads disposed on the bottom surface of the first, second, and third driving ICs 121a, 121b and 121c may be pads that are typically disposed on the second substrate 120 for transmitting signals to and/or receiving signals from the signal transmission substrate 200 and/or the control substrate 300. The pads disposed on the top surface of the first, second, and third driving ICs 121a, 121b, and 121c may be arranged according to the TSVs 1202.

The first and second driving ICs 121a and 121b may be electrically connected by the first signal transmission unit 122a, and the first signal transmission unit 122a connects the first pads 1211 disposed on a second side of the top surface of the first driving IC 121a and 2b_a pads 1212b_a that are disposed on a first side of the bottom surface of the second driving IC 121b.

The second and third driving ICs 121b and 121c may be electrically connected by the second signal transmission unit 122b, and the second signal transmission unit 122b connects a plurality of 2b pads 1212b that are disposed on a second side of the top surface of the second driving IC 121b and 3b_a pads 1213b_a that are disposed on a first side of the bottom surface of the third driving IC 121c.

The first and second signal transmission units 122a and 122b may be flexible metal plates and/or FPCBs.

FIG. 9 is a schematic cross-sectional view illustrating exemplary connections between the driving ICs 121 and the signal transmission units 122 of the display device according to an exemplary embodiment, and FIG. 10 is a schematic top plan view illustrating the driving ICs 121 and the signal transmission units 122 of FIG. 9.

Referring to FIGS. 9 and 10, a plurality of pads may be disposed on the sides of first, second, and third driving ICs 121a, 121b, and 121c corresponding to the TSVs 1202.

Accordingly, first and second signal transmission units 122a and 122b may connect the pads on the sides of the first, second, and third driving ICs 121a, 121b, and 121c, as illustrated in FIG. 10, to transmit signals between the first, second, and third driving ICs 121a, 121b, and 121c.

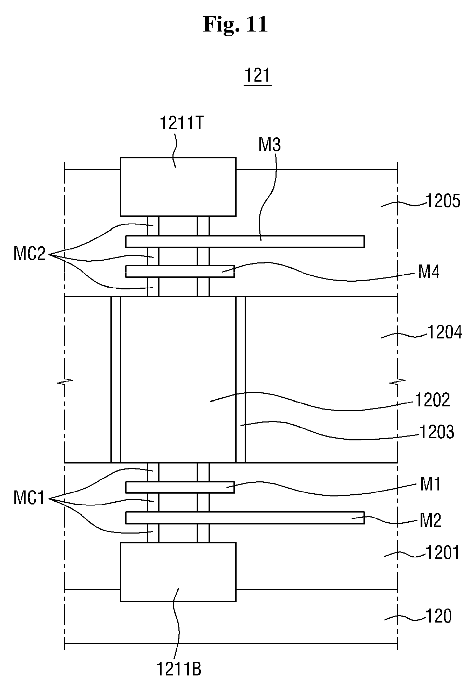

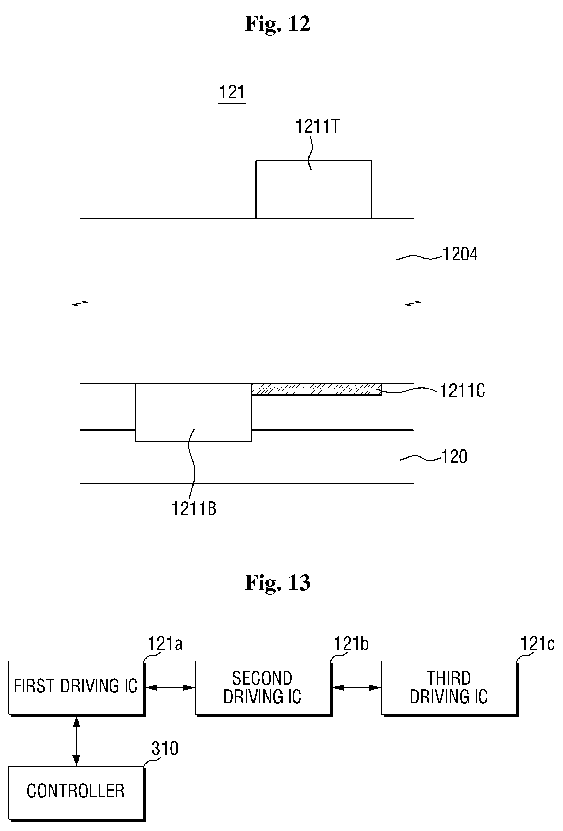

The driving ICs 121 may have a plurality of pads disposed on the top surface and/or bottom surface thereof, or may have a plurality of pads on the sides thereof, instead of at the top surface thereof. A plurality of pads may be disposed on the top surface or the sides of the driving ICs 121 and are electrically connected by the signal transmission units 122 to transmit data and the control signal therebetween, and therefore, the number of LOG-type transmission lines "LOG" disposed on the second substrate 120 may be reduced. Thus, larger data transmission may be enabled and a high-speed interface may be secured by the arrangement of pads at the top surface or the sides of the driving ICs 121. There are two methods for arranging pads at the top surface or the sides of the driving ICs 121, and these two methods will hereinafter be described with reference to FIGS. 11 and 12.

FIG. 11 is a schematic cross-sectional view of an example of a driving IC 121 of the display device according to an exemplary embodiment, taken along a sectional line I-I' of FIG. 3.

Referring to FIG. 11, the driving IC 121 may be mounted on the second substrate 120, and a bottom pad, i.e., a second pad 1211B, may be disposed on a bottom surface of the driving IC 121 that contacts the second substrate 120.

A first metal dielectric layer 1201 may be disposed on the second pad 1211B. The first metal dielectric layer 1201 may be coated with an insulating material (not shown), and may include first and second metal wires M1 and M2 electrically connected to the second pad 1211B, and a first metal contact MC1 electrically connecting the second pad 1211B and the first and second metal wires M1 and M2.

A TSV 1202 may be formed above the first metal dielectric layer 1201 to penetrate a wafer 1204 of the driving IC 121 where electric elements, such as a transistor, are disposed. An insulating layer 1203 may be formed on the sidewalls of the TSV 1202 insulating the TSV 1202 from the electric elements formed in the wafer 1204.

A second metal dielectric layer 1205 may be disposed on the TSV 1202. The second metal dielectric layer 1205 may be coated with an insulating material (not shown) and may include third and fourth metal wires M₃ and M₄ electrically connected to the TSV 1202, and a second metal contact MC2 electrically connecting the TSV 1202 and the third and fourth metal wires M₃ and M₄.

A first pad 1211T may be disposed on the second metal dielectric layer 1205 and on the top surface of the driving IC 121.

More specifically, by forming the TSV 1202 through the wafer 1204 of the driving IC 121, the first pad 1211T may be formed on the top surface of the driving IC 121, but exemplary embodiments are not limited thereto. That is, the first pad 1211T may be disposed as illustrated in FIG. 12, which does not include forming the TSV.

FIG. 12 is a schematic cross-sectional view of another example of a driving IC 121 of the display device according to an exemplary embodiment, taken along the sectional line I-I' of FIG. 3.

Referring to FIG. 12, a driving IC 121 may be mounted on the second substrate 120. A second pad 1211B may be disposed at the bottom surface of a wafer 1204 for transmitting signals to and/or receiving signals from the signal transmission substrate 200, and a first pad 1211T may be disposed on the top surface of the wafer 1204 for transmitting signals to or receiving signals from the driving IC 121. The first and second pads 1211T and 1211B may be formed of a metal coil, and thus may transmit signals due to the magnetic coupling therebetween.

When the first and second pads 1211T and 1211B are formed of a metal material, the driving IC 121 may also include an induction coil 1211C disposed on the bottom surface of the wafer 1204 contacting the second pad 1211B. The induction coil 1211C may induce signal coupled between the first and second pads 1211T and 1211B, and thus may transmit signal between the first and second pads 1211T and 1211B without the TSV.

Referring to FIGS. 11 and 12, the driving ICs 121 may include a high-speed interface by including the TSV through the wafer 1204, by including the first and second pads 1211T and 1211B formed of a metal coil, or by including the induction coil 1211C at the bottom of the wafer 1204. That is, since pads can also be disposed on the top surface of the driving ICs 121 as well as the bottom surface of the driving ICs 121. Therefore, the display device according to an exemplary embodiment may reduce any limits in the amount of data transmission using the LOG-type transmission lines LOG on the second substrate 120 and improve the data processing speed of the display device. Accordingly, the display device according to the current exemplary embodiment may transmit larger data and may provide a high-quality image with a high resolution.

The transmission of signals between the driving ICs 121 and the controller 310 will hereinafter be described with reference to FIGS. 13, 4, 5, and 16, in which driving ICs are arranged in a master-slave manner.

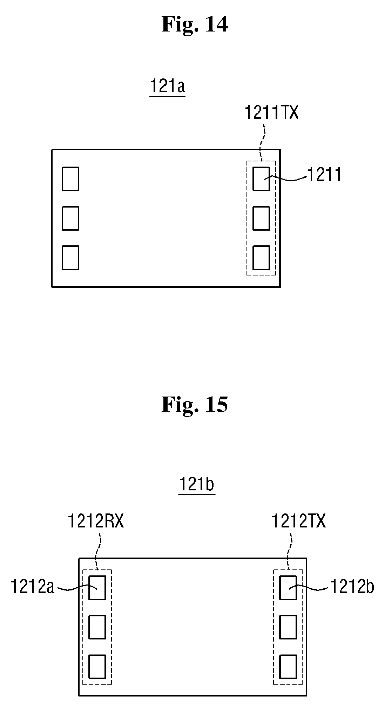

FIG. 13 is a block diagram illustrating exemplary transmissions of signals in the display device according to an exemplary embodiment, and FIGS. 14, 5, and 16 are schematic plan views of the first, second, and third driving ICs 121a, 121b and 121c, respectively, illustrated in FIG. 13.

Referring to FIG. 13, data and a control signal applied by the controller 310 may be transmitted to the first driving IC 121a. Therefore, the first driving IC 121a may be a main driving IC 121M.

The first driving IC 121a, i.e. a main driving IC 121M, may generate and transmit a pixel driving signal to the panel substrate 100 based on the data and the control signal received from the controller 310, and may transmit data that is not processed by the first driving IC 121a to the second driving IC 121b. The first driving IC 121a may operate as a master for the second driving IC 121b. The first driving IC 121a may be electrically connected to the controller 310 via the signal transmission substrate 200 and may be electrically connected to the second driving IC 121b via a signal transmission unit 122. Accordingly, referring to FIG. 14, the first pads 1211, which are disposed on the first driving IC 121a, may be signal transmitting pads 1211Tx configured to transmit signals to the second driving IC 121b.

The second driving IC 121b may generate and transmit a pixel driving signal to the panel substrate 100 based on data and a control signal received from the first driving IC 121a, and may transmit data is not to processed by the second driving IC 121b to the third driving IC 121c. The second driving IC 121b may operate as a master for the third driving IC 121c. The second driving IC 121b may be electrically connected to the first and third driving IC 121a and 121c via a signal transmission unit 122. Accordingly, referring to FIG. 15, the second driving IC 121b may include signal receiving pads 1212Rx configured to receive data and a control signal from the first driving IC 121a and signal transmitting pads 1212Tx configured to transmit data and a control signal to the third driving IC 121c. That is, the 2a pads 1212adisposed on the first side of the second driving IC 121b may correspond to the signal receiving pads 1212Rx, and the 2b pads 1212bdisposed on the second side of the second driving IC 121b may correspond to the signal transmitting pads 1212Tx.

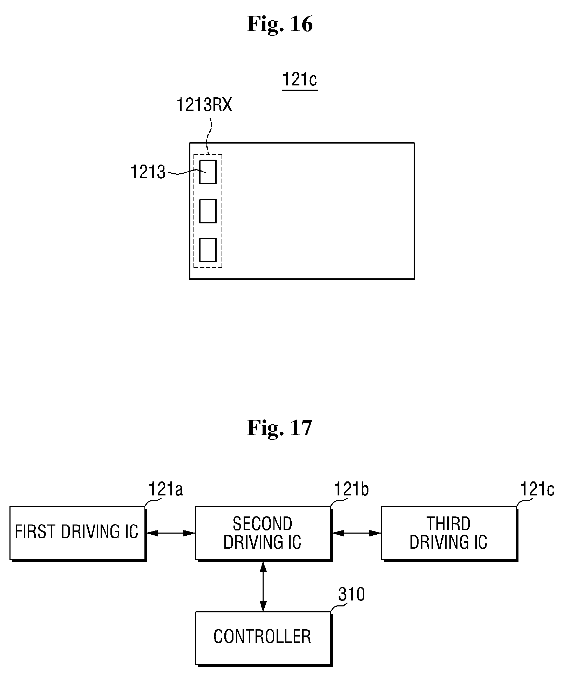

The third driving IC 121c may generate and transmit a pixel driving signal to the panel substrate 100 based on data and a control signal received from the second driving IC 121b. Referring to FIG. 16, the third pads 1213, which are disposed on the third driving IC 121c, may be signal receiving pads 1213Rx configured to receive data and a control signal from the second driving IC 121b.

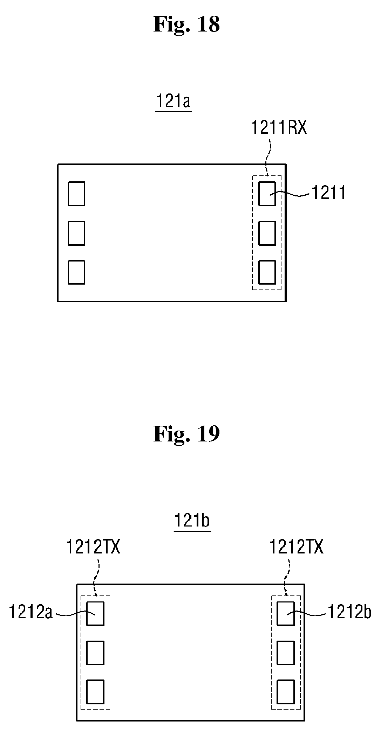

FIG. 17 is a block diagram illustrating exemplary transmissions of signals in the display device according to an exemplary embodiment, and FIGS. 18, 19, and 20 are schematic plan views of the first, second, and third driving ICs 121a,121b and 121c, respectively, illustrated FIG. 17.

Referring to FIG. 17, data and a control signal applied by the controller 310 may be transmitted to the second driving IC 121b. Therefore, the second driving IC 121b may be a main driving IC 121M.

The first driving IC 121a may generate and transmit a pixel driving signal to the panel substrate 100 based on data and a control signal received from the second driving IC 121b. The first driving IC 121a may be electrically connected to the second driving IC 121b via a signal transmission unit 122. Accordingly, referring to FIG. 18, the first pads 1211, which are disposed on the first driving IC 121a, may be signal receiving pads 1211Rx configured to receive signals from the second driving IC 121b.

The second driving IC 121b may generate and transmit a pixel driving signal to the panel substrate 100 based on the data and the control signal received from the controller 310, and may transmit data that is not processed by the second driving IC 121b to the first and third driving ICs 121a and 121c. The second driving IC 121b may be a main driving IC 121M. The second driving IC 121b may be electrically connected to the controller 310 via the signal transmission substrate 200 and may be electrically connected to the first and third driving ICs 121a and 121c via different signal transmission units 122. Accordingly, referring to FIG. 19, the second driving IC 121b may include signal transmitting pads 1212Tx on the first side configured to transmit signals to the first driving IC 121a and signal transmitting pads 1212Tx on the second side configured to transmit signals to the third driving IC 121c. That is, the 2a pads 1212a disposed on the first side of the second driving IC 121b and the 2b pads 1212b disposed on the second side of the second driving IC 121b, may correspond to the signal transmitting pads 1212Tx.

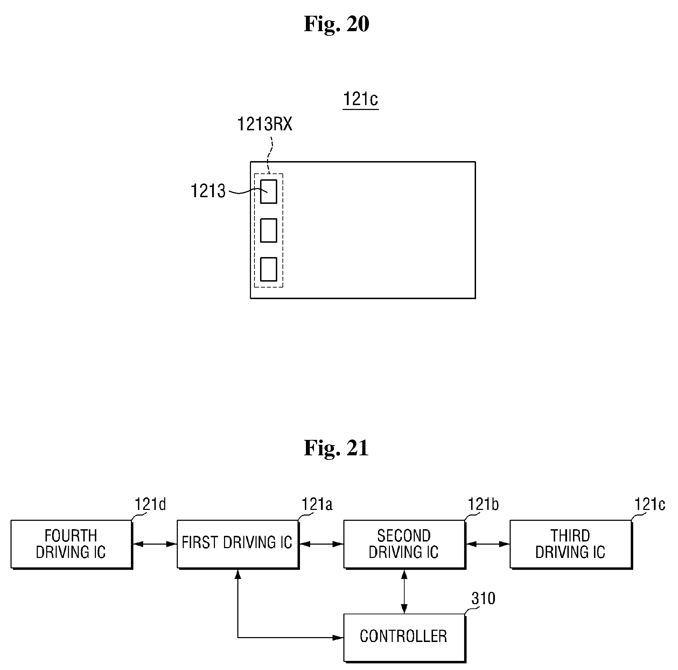

The third driving IC 121c may generate and transmit a pixel driving signal to the panel substrate 100 based on data and a control signal received from the second driving IC 121b. Referring to FIG. 20, the third pads 1213, which are disposed on the third driving IC 121c, may be signal receiving pads 1213Rx configured to receive data and a control signal from the second driving IC 121b.

FIG. 21 is a schematic block diagram illustrating exemplary transmissions of signals in the display device according to an exemplary embodiment.

Referring to FIG. 21, data and a control signal applied by the controller 310 may be transmitted to the first and second driving ICs 121a and 121b. Therefore, the first and second driving ICs 121a and 121b may be main driving ICs 121M.

The first and second driving ICs 121a and 121b may generate and transmit a pixel driving signal to the panel substrate 100 based on the data and the control signal received from the controller 310, and may transmit data that is not processed by the first and second driving ICs 121a and 121b, to the third driving IC 121c and a fourth driving IC 121d, respectively. The first and second driving ICs 121a and 121b may be electrically connected to the controller 310 via the signal transmission substrate 200, and may be electrically connected to the third and fourth driving ICs 121c and 121d, respectively, via different signal transmission units 122. Accordingly, each of the first and second driving ICs 121a and 121b, like the first driving IC 121a in the example of FIG. 14, may include signal transmitting pads for transmitting signals.

The third and fourth driving ICs 121c and 121d may generate and transmit a pixel driving signal to the panel substrate 100 based on data and a control signal received from the first and second driving ICs 121a and 121b, respectively. Each of the third and fourth driving ICs 121c and 121d, like the third driving IC 121c in the example of FIG. 16, may include signal receiving pads configured to receive data and a control signal. Each of the third and fourth driving ICs 121c and 121d may also include signal transmitting pads if there are other driving ICs 121 connected thereto via signal transmission units 122.

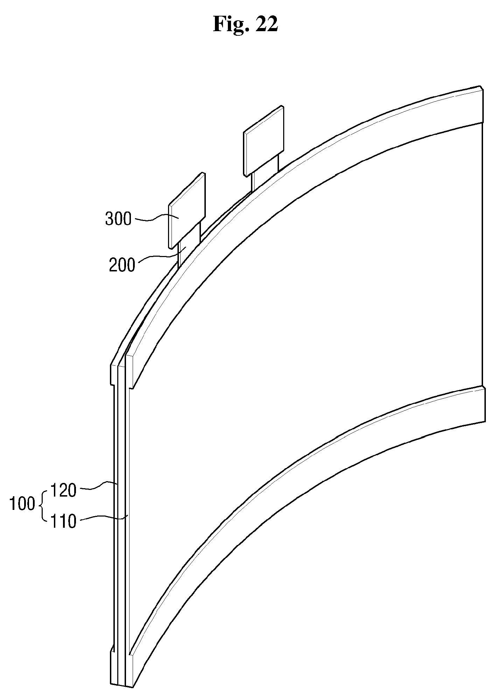

FIG. 22 is a perspective view of a curved display device including the signal transmission substrate 200 and the control substrate 300 of the display device, according to an exemplary embodiment.

Referring to FIG. 22, a curved display device may include the signal transmission substrate 200 and the control substrate 300, such that one or more main driving ICs 121M may be included in an area with a relatively low curvature, i.e., an area with a high level of flatness. Accordingly, the reliability of the bonding among the driving ICs 121, the signal transmission substrate 200 and the control substrate 300 may be improved. The signal transmission substrate 200 and the control substrate 300 may also be disposed to a display device with a flexible substrate, as well as a curved display device.

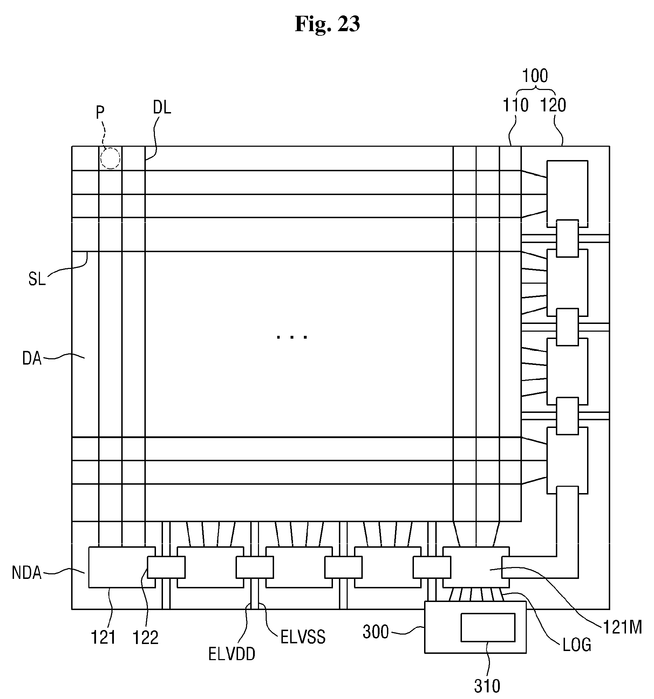

FIG. 23 is a schematic plan view of a display device according to an exemplary embodiment. Referring to FIG. 23, the display device according to an exemplary embodiment may include a panel substrate 100 and a control substrate 300.

The display device according to an exemplary embodiment has a similar structure to the display device according to the pervious exemplary embodiments illustrated in of FIG. 1, but the signal transmission substrate 200 is omitted. Referring to FIG. 23, the control substrate 300 may be electrically connected to the panel substrate 100 without the signal transmission substrate 200.

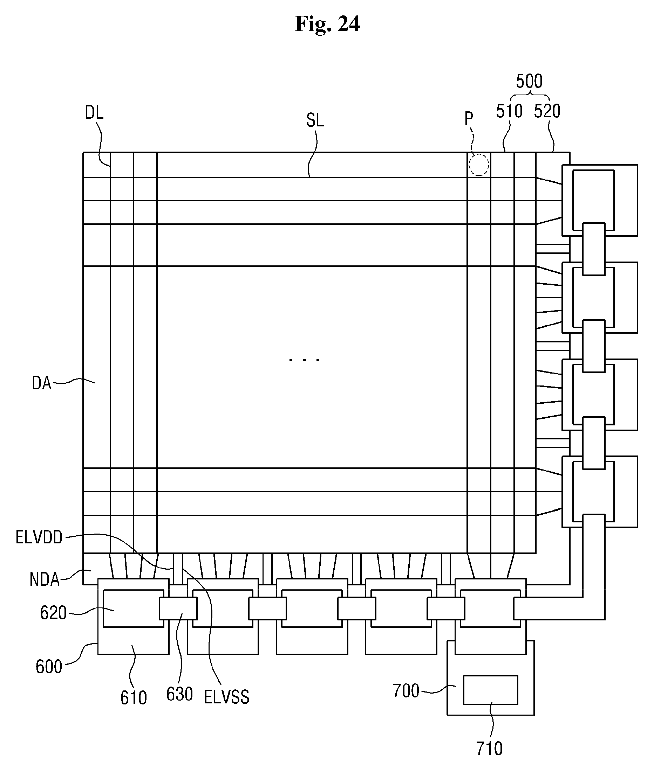

FIG. 24 is a schematic plan view of a display device according to an exemplary embodiment. Referring to FIG. 24, the display device according to an exemplary embodiment may include a panel substrate 500, a plurality of signal transmission films 600 and a control substrate 700.

The panel substrate 500 may include a first substrate 510 and a second substrate 520. A plurality of light-emitting elements for displaying an image may be disposed between the first substrate 510 and the second substrate 520, and an area where the light-emitting elements are disposed may be referred to as a display area DA. A non-display area NDA may refer to area where image is not displayed, and may be provided on the second substrate 520.

In the display area DA, a plurality of scan lines SL, a plurality of data lines DL and a plurality of pixels P may be disposed. Each of the pixels P may include at least one switching elements, for example, thin-film transistor (TFTs), which may be turned on or off according to a control signal applied thereto from the control substrate 700, and a light-emitting element that may emit light under the control of the switching elements.

The non-display area NDA may include a pad area including a plurality of pads connected to the scan lines SL and the data lines DL. The pad area may be connected to the signal transmission films 600.

At least one signal transmission film 600 may be disposed between the panel substrate 500 and the control substrate 700. The signal transmission films 600 may be configured to receive data and a control signal from the control substrate 700 and transmit the received data and the received control signal to the panel substrate 500. The signal transmission films 600 may include flexible insulating films 610 formed of a polyimide (PI) material, driving ICs 620 mounted in the open areas of the flexible insulating films 210, and signal transmission units 630configured to transmit signals between the driving ICs 620 disposed on the signal transmission films 600. The signal transmission films 600 including the driving ICs 620 mounted thereon may be referred to as chip-on-films (COFs). At least one of the signal transmission films 600 may be electrically connected to a controller 710, which is mounted on the control substrate 700. The at least one signal transmission film 600 is connected to the controller 710, configured to transmit signal between the driving ICs 620 disposed on the signal transmission films 600 via the signal transmission units 630. Therefore, the size of the control substrate 700, which is formed of a rigid material, may be reduced, and thereby improving applicability to a curved and/or flexible display device. The connections, and the transmission of signals, between the driving ICs 620, which are mounted on the signal transmission films 600, and the signal transmission units 630 are the same as those in the exemplary embodiments illustrated in FIGS. 3 to 21, and thus, detailed descriptions thereof will be omitted.

The control substrate 700 may be electrically connected to the panel substrate 500 via the signal transmission films 600, and may include the controller 710, which may be configured to control the operation of the driving ICs 620 mounted on the signal transmission films 600. The controller 710 is the same as its counterpart of FIG. 1, and thus, a detailed description thereof will be omitted.

As discussed, embodiments of the invention can provide a display device, comprising: a display panel comprising: pixels configured to display an image; driving integrated circuits, ICs, configured to generate and apply a pixel driving signal for driving the pixels; and at least one signal transmission unit configured to respectively electrically connect the driving ICs to one another, the at least one signal transmission unit being disposed over a surface of the display panel and being spaced apart from the surface of the display panel by a first distance; and a printed circuit board, PCB, comprising a controller configured to receive an image signal from an external source, generate a driving control signal, and apply the driving control signal to the driving ICs. Such embodiments may include a number of driving ICs, with adjacent driving ICs being connected by a signal transmission unit.

Embodiments of the invention can also provide a display device, comprising: a display area comprising pixels, the display configured to display an image; a non-display area comprising: a first driving integrated circuit, IC, configured to apply a pixel driving signal to the pixels; and a second driving IC disposed adjacent to the first driving IC; and a controller electrically connected to the first driving IC, the controller configured to receive an image signal from an external source and apply a driving control signal to the first driving IC, wherein each of the first driving IC and the second driving IC comprises: first pads disposed on first surfaces contacting the non-display area; and second pads disposed on second surfaces, the second surfaces disposed opposite to first surfaces.

Although certain exemplary embodiments and implementations have bee described herein, other embodiments and modifications will be apparent from this description. Accordingly, the inventive concept is not limited to such embodiments, but rather to the broader scope of the presented claims and various obvious modifications and equivalent arrangements.

## Claims

1. A display device, comprising:
a display panel comprising:
pixels configured to display an image;
driving integrated circuits, ICs, configured to generate and apply a pixel driving signal for driving the pixels; and
at least one signal transmission unit configured to electrically connect the driving ICs to one another, the at least one signal transmission unit being disposed over a surface of the display panel and being spaced apart from the surface of the display panel by a first distance; and
a printed circuit board, PCB, comprising a controller configured to receive an image signal from an external source, generate a driving control signal, and apply the driving control signal to the driving ICs.

2. The display device of claim 1, wherein the at least one signal transmission unit is disposed on second surfaces of the driving ICs, the second surfaces being opposite to first surfaces of the driving ICs facing the display panel,
wherein the driving ICs comprise a first driving IC and a second driving IC,
wherein a first end portion of the signal transmission unit contacts the second surface of the first driving IC, and a second end portion of the signal transmission unit contacts the second surface of the second driving IC, and
wherein the second driving IC is disposed adjacent to the first driving IC.

3. The display device of claim 2, wherein the signal transmission unit comprises one selected from a group consisting of a metal plate and a flexible PCB.

4. The display device of any one of claims 1 to 3, wherein the first distance is the same as a thickness of the driving ICs, and
an insulating material is disposed in gaps between the display panel and the signal transmission units.

5. The display device of any one of claims 1 to 4, wherein the driving ICs comprise at least one main driving IC electrically connected to the controller.

6. The display device of claim 5, further comprising transmission lines configured to electrically connect the main driving IC to the controller.

7. The display device of any one of claims 1 to 6, wherein the driving ICs are mounted on the display panel in a manner selected from a group consisting of a chip-on-glass, COG, manner and a chip-on-film, COF, manner.

8. A display device, comprising:
a display area comprising pixels, the display being configured to display an image;
a non-display area comprising:
a first driving integrated circuit, IC, configured to apply a pixel driving signal to the pixels; and
a second driving IC disposed adjacent to the first driving IC; and
a controller electrically connected to the first driving IC, the controller being configured to receive an image signal from an external source and apply a driving control signal to the first driving IC,
wherein each of the first driving IC and the second driving IC comprises:
first pads disposed on first surfaces contacting the non-display area; and
second pads disposed on second surfaces, the second surfaces disposed opposite to first surfaces.

9. The display device of claim 8, wherein each of the first and second driving ICs comprise a through silicon via, TSV, the TSV being formed through the corresponding driving IC.

10. The display device of claim 8 or 9, wherein each of the first and second driving ICs comprises an induction coil disposed on the first surface and extending from the first pads.

11. The display device of any one of claims 8 to 10, further comprising:
a signal transmission unit configured to transmit a signal from the first driving IC to the second driving IC.

12. The display device of claim 11, wherein the signal transmission unit contacts the second pads of the first driving IC and the second pads of the second driving IC.

13. The display device of claim 11 or 12, wherein the first driving IC is connected to the controller, and signals are configured to be transmitted between the first driving IC and the second driving IC in a master-slave manner.

14. The display device of claim 13, wherein the second pads of the first driving IC comprise signal transmitting pads.

15. The display device of claim 14, wherein the second pads of the second driving IC comprise signal receiving pads.
